Europäisches Patentamt

European Patent Office

Office européen des brevets

(11) Publication number: **0 468 428 A2**

# EUROPEAN PATENT APPLICATION

(21) Application number: **91112295.0**

(22) Date of filing: **23.07.91**

(51) Int. Cl.⁵: **H01L 39/12**, C04B 35/00

(30) Priority: **25.07.90 JP 197287/90**
**05.11.90 JP 300389/90**
**05.11.90 JP 300390/90**

(43) Date of publication of application:
**29.01.92 Bulletin 92/05**

(84) Designated Contracting States:
**DE FR GB**

(71) Applicant: **MATSUSHITA ELECTRIC INDUSTRIAL CO., LTD.**
**1006, Kadoma**
**Kadoma-shi, Osaka-fu 571(JP)**

(72) Inventor: **Adachi, Seiji**
**6-7-203, Narita-cho**
**Neyagawa-shi, Osaka, 572(JP)**
Inventor: **Setsune, Kentaro**
**4-24-9, Niwashirodai**
**Sakai-shi, Osaka, 590-01(JP)**

(74) Representative: **Eisenführ, Speiser & Strasse**
**Martinistrasse 24**
**W-2800 Bremen 1(DE)**

(54) **Oxide superconductor material and manufacturing method thereof.**

(57) An new oxide superconductor material having a crystal structure including first, second and third layers: In the first layer, octahedrons having a copper atom at the center and oxygen atoms at their vertices extend in two-dimension by sharing vertices of the octahedrons. In the second layer, octahedrons having a lead or copper atom at the center and oxygen atoms at their vertices extend in two-dimension by sharing sides of the octahedrons. The first and second layers are layered by sharing oxygen atoms at vertices of the octahedrons. The third layer includes the oxygen atoms shared by the first and second layers, alkaline earth atoms and rare earth atoms. The first, second and third layers are layered successively.

## BACKGROUND OF THE INVENTION

### Field of the Invention

The present invention relates to an oxide superconductor material having a high transition temperature and a manufacturing method thereof.

### Description of the Prior Art

Superconductor materials have characteristics such as zero electric resistance and perfect diamagnetism, not realized by other materials, and they are expected to be applied in wide areas such as electric power transportation, electric generator, plasma containment in nuclear fusion, magnetic levitation train, magnetic shield or high speed computer. Superconductor materials available practically now are metallic materials such as Nb, Pb, NbTi or NbSn. However, the highest superconducting transition temperature of the metallic superconductors is about 23 K. Then, it is a large problem in industry that superconductors need to be cooled for practical operation by using expensive liquid helium and a large-scale thermally insulated apparatus. Therefore, new superconductors having higher transition temperatures were searched.

In 1986, J. G. Bednorz and K. A. Muller discovered an oxide superconducting material $(La_{1-z}Ba_z)_2CuO_2$ of a higher superconducting transition temperature of about 30 K. Further, oxide materials such as $YBa_2Cu_3O_x$, Bi-Sr-Ca-Cu-O and Tl-Ba-Ca-Cu-O have been reported to have higher superconducting transition temperatures. If the superconducting transition temperature becomes higher, the superconductor material becomes easier to be cooled, and it is expected to have a higher critical current density and a higher critical magnetic field when used at the same temperature, so that the application areas will be widened. Therefore, new oxide superconductors have been searched while many studies have been performed on manufacturing methods, physical properties and applications of these materials.

Among oxide superconductors is included a group of lead oxide superconductors including lead, copper and oxygen and having a basic portion based on rock-salt structure. They are expected as the most appropriate materials for developing new devices in combination with other lead oxide materials, especially those having perovskite structure which have been studied. This group are classified into one, two and three sheets of atomic layer in a Pb-Cu-O rock-salt structure portion. The lead oxides of the two or three sheets need two stage heat treatments of sintering in oxygen or air environment and of annealing in inert gas environment. Those of the one sheet have an advantage that they can be manufactured by using one stage heat treatment in oxygen environment, whereas it is a problem to control the composition thereof because the number of the constituent elements is as large as six or more.

## SUMMARY OF THE INVENTION

An object of the present invention is to provide new lead oxide superconductors having high superconducting transition temperatures and a manufacturing method thereof.

A novel type superconductor material according to the present invention has a crystal structure including first, second and third layers: In the first layer, octahedrons having a copper atom at the center and oxygen atoms at their vertices extend in a two-dimensional plane by sharing vertices of the octahedrons. In the second layer, octahedrons having a lead or copper atom at the center and oxygen atoms at their vertices extend in two-dimensional plane by sharing sides of the octahedrons. The first and second layers are layered by sharing oxygen atoms at vertices of the octahedrons. The third layer includes the oxygen atoms shared by the first and second layers, alkaline earth atoms and rare earth atoms. The first, second and third layers are layered successively.

In manufacturing the above-mentioned superconductor material, a fired product of the material is subjected further to heat treatment such as annealing under inert gas environment, annealing under oxygen gas environment or rapid cooling.

It is an advantage of an oxide superconductors according to the present invention that they have 30 K or more of superconducting transition temperature $T_c$.

It is another advantage of the present invention that the number of the constituents elements is the smallest among lead oxide superconductors or the new superconductors are simple systems.

It is an advantage of a manufacturing method of the oxide superconductor according to the present invention that good superconducting characteristics can be obtained very easily without using complex heat treatment necessary for known lead oxide superconductors.

## BRIEF DESCRIPTION OF THE DRAWINGS

These and other objects and features of the present invention will become clear from the following description taken in conjunction with the preferred embodiments thereof with reference to the accompanying drawings, in which:

Fig. 1 is a powder X-ray diffraction spectra of an oxide superconductor $(Pb_{0.6}Cu_{0.5})(Sr_{0.5}La_{0.5})_2 CuO_y$, and

Fig. 2 is a diagram of the crystal structure of an oxide superconductor.

## DETAILED DESCRIPTION OF THE PREFERRED EMBODIMENTS

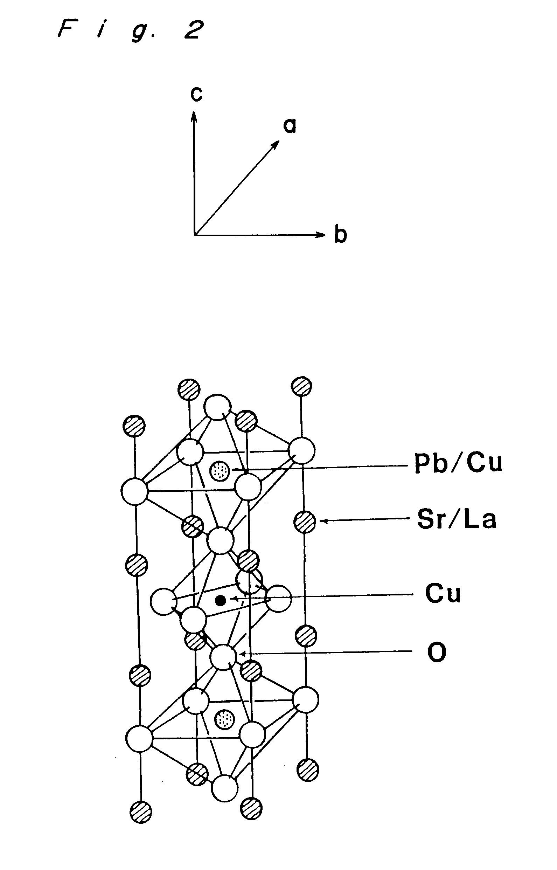

Starting materials used for manufacturing lead oxide superconductors of the composition formula $(Pb_{0.6}Cu_{0.5})(Sr_{1-x}La_x)_2 CuO_y$ are powders of PbO, $La_2O_3$, $SrCO_3$ and CuO each of purity of 99.5 % or more. The amount 0.6 of lead is increased more than 0.5 which is expected from the crystal structure shown in Fig. 2 because lead is liable to evaporate. The value y of oxygen is about five. The compositions of the oxides are changed so that a variable x is changed between 0.0 and 1.0 at intervals of 0.1. The powders are mixed for an hour with a $ZrO_2$ ball mill of 2 mm of diameter with use of ethanol as a dispersing agent. After completing the mixing, all material including the dispersing agent are dried at 120 °C, and the dried material is fired in air at 800 °C for five hours. Then, the material is crushed and mixed with the vibrating mill for an hour and is dried with use of a process similar to that as explained above. Then, 0.4 g of the powders are compressed with an axial pressure and are formed in a dye of 15 mm × 5 mm at 600 kg/cm$^2$ of pressure. The formed material is fired at 1000 °C for two hours in oxygen environment in an electric furnace. The rising rate of temperature is 300 °C/h, while the material is allowed to be cooled in the furnace.

The crystal structures of the obtained sintered materials are investigated with the powder X-ray diffraction analysis. The temperature dependence of electrical resistance of the materials is measured between room temperature and 15 K with the four-probe technique by using 10 mA of measurement current, and superconducting characteristics, $T_c^{on}$ and $T_c^{zero}$, are obtained, wherein $T_c^{on}$ and $T_c^{zero}$ designate temperatures at which the resistance begins to decrease sharply and becomes zero, respectively. Further, the temperature dependence of magnetic susceptibility of the materials are measured, and the temperature, $T_c^{M}$, at which the magnetic susceptibility of the materials starts to change rapidly due to the Meissner effect.

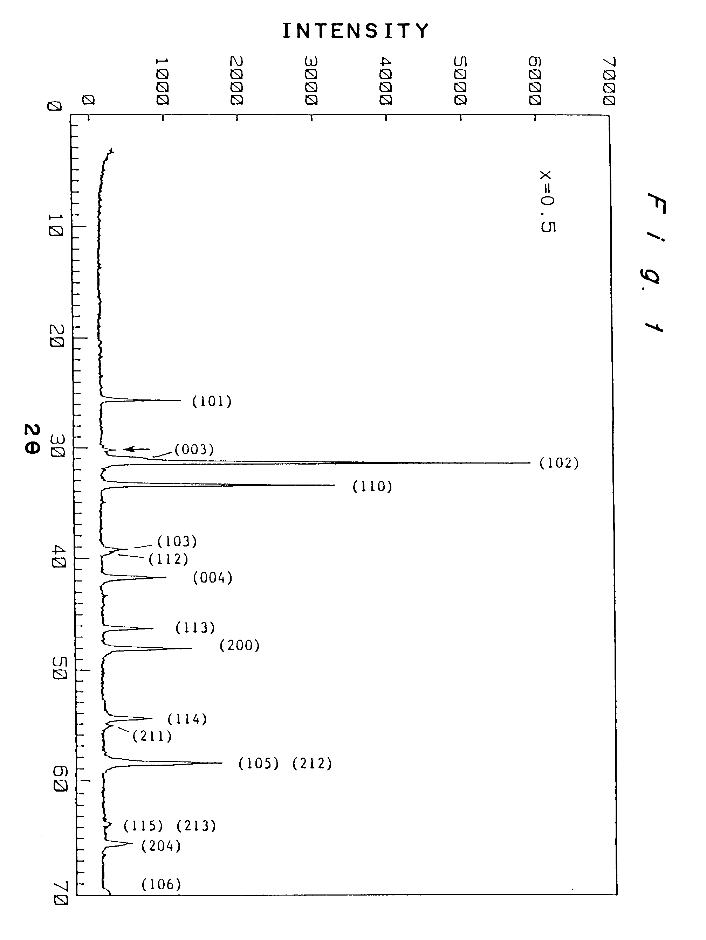

If $0.2 \leq x \leq 0.7$, materials $(Pb_{0.6}Cu_{0.5})(Sr_{1-x}La_x)_2 CuO_y$ of a phase belonging a tetragonal crystal system of lattice constants of a = 0.378 nm and c = 0.867 nm can be synthesized. Especially, a single phase material can be obtained at a composition of x = 0.5. Fig. 1 shows the X-ray diffraction pattern of the material wherein an arrow displays a peak due to impurities. The Rietveld analysis of the X-ray diffraction data except the impurity data shows that the sample of x = 0.5 has a crystal structure, shown in Fig. 2, having first, second and third layers: In the first layer, octahedrons having a copper atom at the center and oxygen atoms at their vertices extend in a two-dimensional plane by sharing vertices of the octahedrons. In the second layer, octahedrons having a lead or copper atom at the center and oxygen atoms at their vertices extend in a two-dimensional plane by sharing sides of the octahedron. The first and second layers are layered by sharing oxygen atoms at vertices of the octahedrons. The third layer includes the oxygen atoms shared by the first and second layers, alkaline earth atoms (Sr) and rare earth atoms (La). The first, second and third layers are layered successively as shown in Fig. 2.

Table 1 shows the superconducting characteristics of materials of x between 0.2 and 0.8.

3

TABLE 1    Transition temperature of oxide superconductors

| composition x | transition temperature (K) | | |
|---|---|---|---|
| | $T_c^{on}$ | $T_c^{zero}$ | $T_c^M$ |
| 0.2 | – | – | – |
| 0.3 | 24 | – | – |
| 0.4 | 24 | 20 | 22 |
| 0.5 | 29 | 25 | 31 |
| 0.6 | 30 | 24 | 23 |
| 0.7 | 28 | – | – |
| 0.8 | – | – | – |

Table 2 shows the transition temperatures ($T_c^{on}$, $T_c^{zero}$ and $T_c^M$) and the electrical resistivity at room temperature of samples of composition x = 0.5 when the cooling rate on firing is changed.

TABLE 2        Effect of cooling on $T_c$ and resistivity

| | transition temperature (K) | | | resistivity at room temperature ($\Omega \cdot cm$) |
|---|---|---|---|---|
| cooling | $T_c^{on}$ | $T_c^{zero}$ | $T_c^M$ | |
| slow cooling | 34 | 29 | 35 | 0.0056 |
| furnace cooling | 29 | 25 | 31 | 0.0058 |
| rapid cooling | 36 | 23 | 38 | 0.016 |

As shown in Table 2, it is clear that superconducting characteristics of the order of 30 K can be obtained easily without especially taking notice of cooling conditions. It is confirmed by the X-ray diffraction analysis that every sample has the above-mentioned basic crystal phase invariably. By observing fractured sections of samples under slow cooling, under the furnace cooling and under rapid cooling with a scanning electron microscope, it is found that the fracture mode of samples of slow cooling and of the furnace cooling are fractured transgranularly and the grains are binded closely. The good conductivity character of low resistivity of these samples is ascribable to this fact. Grains are grown most in samples of slow cooling, and a fractured section is shown to have weak-coupling least between grain boundaries. Further, the annealing in oxygen (500 - 900 °C and cooled for 24 h) has an effect to enhance the binding between crystal grains and to decrease the resistivity at room temperature, while $T_c^M$ is not affected hardly.

On the other hand, samples of rapid cooling has higher resistivity at room temperature and lower $T_c^M$ than those of samples of slow cooling, while they have $T_c^M$ as high as 38 K. This suggests that the transition temperature of the superconducting phase of the present invention may be enhanced by treating the phase under reduction environment. Then, the samples of slow cooling are subjected to annealing under nitrogen (400 - 700 °C and cooled for 24 h). The results are summarized in Table 3, wherein a circle mark in the X-ray analysis column designates a single phase, while a triangle mark designates inclusion of impurity phase.

As displayed in Table 3, it is found that the annealing under nitrogen at 450 - 600 °C makes it possible to manufacture a ceramic having a single phase and hard binding between grain boundaries.

## TABLE 3   Effect of annealing

| annealing temperature (°C) | transition temperature (K) | | | X-ray dif-frac-tion | fracture mode |
|---|---|---|---|---|---|
| | $T_c^{on}$ | $T_c^{zero}$ | $T_c^{M}$ | | |
| before annealing | 34 | 29 | 35 | O | transgranular |
| 450 | 35 | 34 | 36 | O | transgranular |
| 500 | 36 | 33 | 36 | O | transgranular |
| 550 | 36 | 33 | 37 | O | transgranular |
| 600 | 36 | 34 | 37 | O | transgranular |
| 650 | 37 | 32 | 38 | O | grain boundary |
| 700 | 38 | 30 | 39 | Δ | grain boundary |

As explained above, the superconductor characteristics of the new superconductors can be improved by using annealing under inert gas environment, annealing under oxygen gas environment or rapid cooling.

Further, it is found that strontium can be replaced partially with barium or calcium while lanthanum can be replaced partially with other rare earth element.

## Table 4   Transition temperature of lead oxide

## superconductors

| composition | transition temperature (K) | | |
|---|---|---|---|
| | $T_c^{on}$ | $T_{czero}$ | $T_c^{M}$ |
| $Pb_{0.6}Sr_{0.5}Pr_{0.5}Cu_{1.5}O_y$ | 26 | 23 | 22 |
| $Pb_{0.6}Sr_{0.5}Nd_{0.5}Cu_{1.5}O_y$ | 27 | 22 | 23 |
| $Pb_{0.6}Sr_{0.5}Sm_{0.5}Cu_{1.5}O_y$ | 25 | 21 | 20 |
| $Pb_{0.6}Sr_{0.5}Eu_{0.5}Cu_{1.5}O_y$ | 23 | 19 | 22 |
| $Pb_{0.6}Sr_{0.5}Gd_{0.5}Cu_{1.5}O_y$ | 21 | 16 | 19 |
| $Pb_{0.6}Ba_{0.5}La_{0.5}Cu_{1.5}O_y$ | 28 | 23 | 23 |
| $Pb_{0.6}Ca_{0.5}La_{0.5}Cu_{1.5}O_y$ | 27 | 22 | 23 |

Still further, Table 4 displays transition temperatures of lead oxide superconductors including rare earth other than lanthanum or alkaline earth other than strontium. They also can be prepared as sintered material almost of single phase, and they are all superconductors.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

**Claims**

1. An oxide superconductor material having a crystal structure including first, second and third layers; the first layer including octahedrons having a copper atom at the center and oxygen atoms at their vertices octahedrons extending in a two-dimension plane by sharing vertices of adjacent octahedron; the second layer including octahedrons having a lead or copper atom at the center and oxygen atoms at their vertices, which octahedrons extending in a two-dimensional plane by sharing sides of adjacent octahedrons; the first and second layers are layered by sharing oxygen atoms at vertices of the octahedrons, which oxygen atoms located away from the two-dimensional planes; and the third layer including the oxygen atoms shared by the first and second layers, alkaline earth atoms and rare earth atoms.

2. An oxide superconductor material according to Claim 1, wherein said alkaline element is strontium and said rare earth is lanthanum.

3. A manufacturing method of an oxide superconductor material according to Claim 2, comprising the steps of firing a compressed body of the oxide superconductor material and cooling the fired material rapidly.

4. A manufacturing method of an oxide superconductor material according to Claim 2, comprising the steps of firing a compressed body of the oxide superconductor material in oxygen environment and cooling the material slowly.

5. A manufacturing method of an oxide superconductor material according to Claim 2, comprising the steps of firing a compressed body of the oxide superconductor material and annealing the material at 500 - 900 °C in oxygen environment.

6. A manufacturing method of an oxide superconductor material according to Claim 2, comprising the steps of firing a compressed body of the oxide superconductor material and annealing the material at 450 - 600 °C under nitrogen environment.

F i g. 1

*F i g. 2*